# EUROPEAN PATENT SPECIFICATION

(11) **EP 4 293 796 B1**
(45) Date of publication and mention of the grant of the patent: **10.06.2026**
(21) Application number: 22771684.2
(22) Date of filing: 11.03.2022
(51) Int. Cl.: H01M 10/48, H01M 50/583, H01M 10/42, H01H 85/165, H01H 85/143, G01H 11/06, G01R 19/165, H01M 50/242, G01H 1/00, H01H 85/20, H01M 50/204, H01M 50/209, H01M 50/211, H01M 50/296, H01M 50/569

(54) **PROTECTIVE CIRCUIT FOR SENSING VIBRATION OF FUSE BOX**
SCHUTZSCHALTUNG ZUR ERFASSUNG DER VIBRATION EINES SICHERUNGSKASTENS
CIRCUIT DE PROTECTION POUR DÉTECTER LES VIBRATIONS D'UNE BOÎTE À FUSIBLES

(30) Priority: 16.03.2021 KR 20210034141
(43) Date of publication of application: 20.12.2023
(73) Proprietor: LG Energy Solution, Ltd., Seoul 07335 (KR)
(72) Inventor: SHIN, Hak Yong, Daejeon 34122 (KR)
(74) Representative: Plasseraud IP
(86) International application number: PCT/KR2022/003488
(87) International publication number: WO 2022/197018

(56) References cited:
- WO-A1-2014/034710
- JP-A- 2018 037 364
- KR-A- 20060 110 771
- KR-A- 20110 060 166
- KR-A- 20170 003 565
- KR-A- 20180 073 764

## Description

### TECHNICAL FIELD

The present invention relates to a battery pack for a vehicle for detecting vibration flowing into a fuse box and a bus bar of the battery pack, and more particularly, to a battery pack including a vibration detection element that detects vibration flowing into the fuse box and the bus bar from the outside.

### BACKGROUND ART

Recently, as regulations related to automobile exhaust gas have been strengthened due to environmental pollution, a demand for an eco-friendly vehicle is increasing. For this reason, research and development on an electric vehicle that receives electric energy from the outside, charges a battery, and drives a motor with the electric energy supplied by the battery to obtain power is being actively conducted.

The battery of this electric vehicle may be configured in various battery modules by connecting a number of battery cells in series with/parallel to each other according to a required power voltage and charge/discharge capacity. A battery pack structure is configured by adding a configuration such as a protection circuit to the battery module including at least one battery cell.

A fuse used in the electric vehicle is melt and broken when an overcurrent flows in the battery module or pack circuit to block the circuit, thereby protecting the battery cell from ignition and damage. A plurality of fuses formed to be connected to the battery module and pack installed in the vehicle are aggregated so that the fuses may be coupled to and separated from each other in the fuse box.

In recent electric vehicles, as the number of battery cells increases as a number of battery cells are connected in a series/parallel connection structure and the module becomes larger, and thus, external vibrations and shocks generated during vehicle operation flow into the interior. Accordingly, the probability of occurrence of damage such as disconnection between the fuse or the fuse box and the bus bar increases. When the fuse box and bus bar of the battery pack are broken, a problem occurs in user stability due to the phenomenon of insensitivity to power of the battery pack.

The background technology of the present invention is published in the following patent documents.
(Patent Document 1) KR 2020-0011810 A
(Patent Document 2) JP 2019-087723 A
(Patent Document 3) KR 2020-0090101 A
(Patent Document 4) KR 2014-0117154 A. WO2014/034710 A1 relates to a system for monitoring a vehicle battery.

### DISCLOSURE OF THE INVENTION

### TECHNICAL PROBLEM

The present invention provides a means for detecting vibration in a fuse box which is vulnerable to vibration in a battery pack and to which the vibration applied to the battery pack is delivered well in order to effectively detect the vibration applied to the battery pack.

In addition, the present invention is intended to provide a battery pack capable of increasing user stability from damage to the fuse box vulnerable to vibration and breakage caused by disconnection with the bus bar by detecting vibration applied to the fuse box of the electric vehicle through a vibration detection element.

### TECHNICAL SOLUTION

A battery pack according to claim 1 is provided in an aspect of the present invention.

The vibration detection element is characterized in that it is attached to the bus bar and fuse box in a form of a tape or a form of a FPCB transferred on a flexible substrate to sensitively sense the inflow of vibration, and is not damaged even by a temporary impact.

The fuse box and the bus bar are characterized in that cumulative damage is generated therein due to vibration flows into from the outside.

The vibration detection element is characterized in that it measures a change in voltage value according to vibration detection of the bus bar and the fuse box and delivers it to the BMS, and the BMS is characterized in that it compares the voltage value with a predetermined reference level, and performs a protection operation and transmits an alarm to a user when a maximum allowable level at the predetermined reference level is exceeded.

### ADVANTAGEOUS EFFECTS

According to an embodiment of the present invention, a battery pack is configured to include a battery module, a bus bar electrically connecting the battery module, and a fuse box in which a fuse is accommodated, and include a vibration detection element attached to one surface of the fuse box or one surface of the bus bar. The fuse box or bus bar is a site where accumulated damage due to vibration flowing into from the outside of the battery pack is greatly generated, and the vibration detection element is attached thereto so that the vibration may be sensitively detected. The vibration detection element detects vibration flown into through the fuse box and the bus bar and transmits a change in voltage value according to the detected vibration to the BMS connected to both ends of the vibration detection element. By comparing the received voltage value with a predetermined reference level and performing a protection operation, the BMS may prevent loss of an overcurrent blocking function, such as the phenomenon of insensitivity of the fuse box due to vibration flowing into from the outside of the battery pack in advance.

### BRIEF DESCRIPTION OF THE DRAWINGS

FIG. 1 is a battery pack according to an embodiment of the present invention.
FIG. 2 is a battery module according to an embodiment of the present invention and a battery pack including the same.
FIG. 3 is a configuration diagram of a fuse according to the present invention.
FIG. 4 is a configuration diagram of a fuse box according to the present invention.
FIG. 5 is a configuration diagram of a fuse case according to the present invention except for a fuse cover.
FIG. 6 illustrates a battery pack according to another embodiment of the present invention.

### MODE FOR CARRYING OUT THE INVENTION

Hereinafter, with reference to the accompanying drawings, embodiments of the present invention will be described in detail. However, the present invention is not limited to the embodiments disclosed below, and will be implemented in various different forms. The embodiments of the present invention are provided only to make the disclosure of the present invention complete, and to fully inform the scope of the invention to a person with ordinary knowledge in the art. In order to explain the embodiment of the present invention, the drawings may be exaggerated, parts irrelevant to the description may be omitted from the drawings, and the same reference numerals in the drawings refer to the same elements.

Hereinafter, an embodiment of the present invention will be described with reference to the drawings.

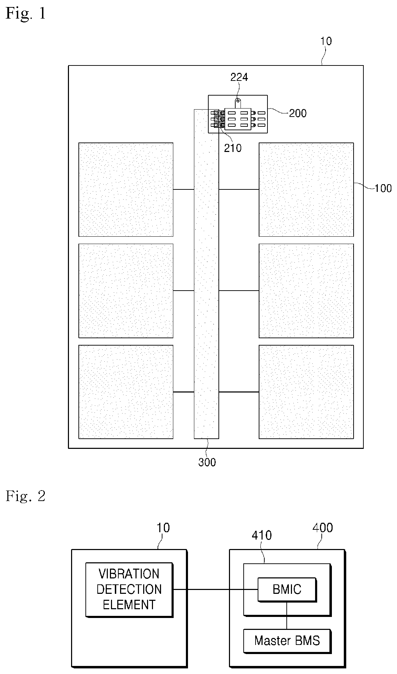

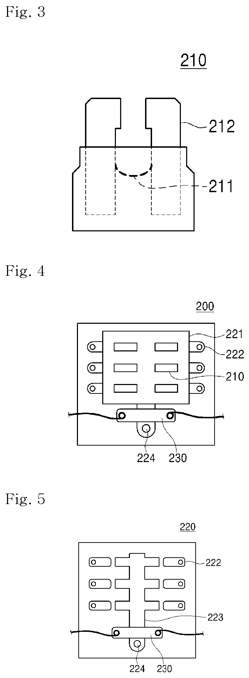

Referring to Figure 1, the present invention is configured with a battery pack 10 including a battery module 100, a fuse box 200, which includes a fuse 210, a fuse case 220 (see Figure 5), and a vibration detection element 230 (see Figure 4 or 5), and a bus bar 300, and a battery management system (BMS) 400 (see Figure 2) that controls the battery pack 10.

### 1. Configuration of the battery pack of the present invention

### A. battery module 100

The battery module 100 is configured by connecting a plurality of battery cells in series with or in parallel to each other, and at least one of these battery modules 100 is connected to configure the battery pack 10. The plurality of battery cells may be configured as cylindrical, pouch, and prismatic battery cells. In addition, the type of the battery cell may include, but is not limited to, a lithium ion battery, a lithium polymer battery, a nickel cadmium battery, and a nickel hydride battery.

### B. fuse box 200

FIG. 4 illustrates a configuration of the fuse box 200 of the present invention. The fuse box 200 is configured with a fuse 210, a fuse case in which the fuse 210 is accommodated, and the vibration detection element 230 attached to one surface of the fuse case, and facilitates coupling and disengagement of the fuse during operation such as fuse exchange. The fuse box 200 may be disposed inside the battery pack 10 at a position between a terminal of each battery module 100 and the bus bar 300 to which the fuse box 200 is connected, and may also accommodate a plurality of fuses 210 so as to be disposed at one end of the bus bar 300 connected to the outside of the battery pack 10.

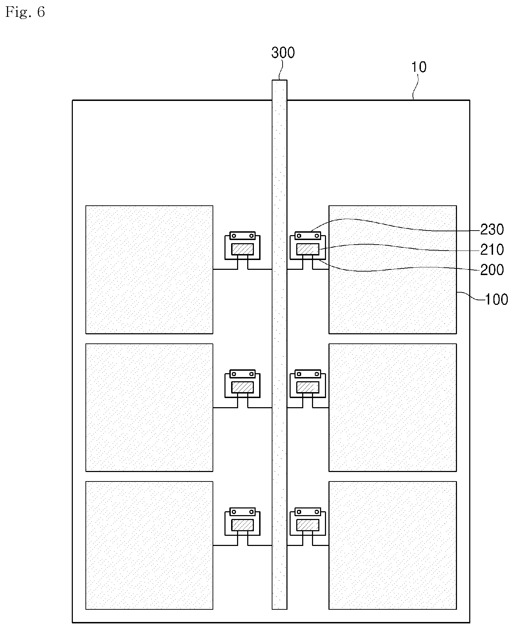

The fuse box 200 may be formed at a portion where an electrode terminal of the battery pack and the bus bar are connected as illustrated in FIG. 1, or may be formed at a connection portion between respective battery modules 100 and the bus bar as illustrated in FIG. 6.

When formed as illustrated in FIG. 1, one end of the bus bar 300 is connected to the BMS 400 of FIG. 2. In this case, a fuse case-battery terminal of the fuse box 200 and one end of the bus bar 300 may be connected, and the BMS 400 may be connected to a fuse case terminal 224.

When describing with reference to FIGS. 3 to 6, although the fuse boxes 200 are illustrated as being connected between each battery module 100 and the bus bar 300, an additional fuse box 200 may be disposed to connect one end of the bus bar 300 and the electrode terminal (not illustrated) of the battery pack 10.

### (1) fuse 210

The fuse 210 is configured to be coupled to a circuit through which the charging/discharging current of the battery module 100 flows, and is coupled between the battery module 100 and the bus bar 300 to connect each of the at least one or more battery modules 100 to the bus bar 300 through the fuse 210. When connected to the fuse box 200, the bus bar 300 and the electrode terminal (not illustrated) of the battery pack 10 or the bus bar 300 and the external BMS 400 are connected through the fuse 210.

The fuse 210 may be accommodated in the fuse box 200 and positioned at each connection portion connected between the battery module 100 and the bus bar 300. A plurality of fuses 210 may be accommodated in one fuse box 200 and positioned at one end of the bus bar 300 connected to the external terminal (an electrode terminal or a terminal connected to BMS) of the battery pack 10.

FIG. 3 illustrates a detailed configuration of the fuse 210.

The fuse 210 is configured to include a fuse terminal 212 and is inserted into the fuse case to be connected to the fuse case-battery terminal 222 (see Figure 4 or 5) to couple the battery module 100 to an external device and the battery management system.

The fuse 210 is made of metal such as copper and tin. In the fuse 210, when an overcurrent flows through the battery module 100 or the circuit of the pack, a fuse breakage part 211 is melted to block the battery module 100 from the overcurrent.

In the fuse 210, when continuous vibration from the outside occurs, the fuse breakage part 211 is physically broken, which may cause the phenomenon of insensitivity in relation to the battery pack 10 and thus lose an overcurrent blocking function, thereby causing a problem in user safety. The vibration detection element 230 of the present invention detects vibration from the outside in order to prevent or detect the loss of the overcurrent blocking function in advance.

### (2) fuse case 220

FIG. 5 illustrates a structure of the fuse case 220. The fuse case of FIG. 5 may have a structure covered with a fuse cover 221 as illustrated in FIG. 4. The fuse case is provided with the fuse cover 221 including a fuse accommodation part capable of accommodating the fuse 210 therein, and a fuse case terminal 224 is formed inside the fuse accommodation part.

In the case of the disposition illustrated in FIG. 6, the bus bar 300 is connected to one end of the fuse case terminal 224, and the terminal of the battery modules 100 is connected to the fuse case-battery terminal 222, and thus the bus bar 300 and the battery module 100 are connected through the fuse 210.

In the case of the disposition as illustrated in FIG. 1, the bus bar 300 is connected to the fuse case-battery terminal 222, the fuse case terminal 224 is connected to the BMS 400, and thus the fuse 210 is disposed to form a path between the bus bar 300 and the BMS 400. Alternatively, in contrast to this, a configuration in which one end of the bus bar 300 is connected to the fuse case terminal 224 and the fuse case-battery terminal 222 is connected to the BMS 400 may be adopted.

Conventionally, abnormalities such as disconnection of the circuit connecting the fuse 210 or the battery module 100 and the bus bar 300 could occur due to the breakage of the fuse case. When a problem with the fuse 210 occurs, the battery module 100 or the pack is not blocked from overcurrent or the phenomenon of insensitivity to power of the battery pack 10 is caused, thereby causing a problem in the stability of a user who uses the battery pack 10.

### (3) vibration detection element 230

The vibration detection element 230 is mounted at a position where the vibration from the outside of the battery pack 10 is delivered more sensitively to the fuse 210 in a process of being delivered to the inside and is attached to detect the vibration.

The vibration detection element 230 is disposed to be insulated from each of the wires/fuses in the fuse box.

The vibration detection element 230 is configured to directly detect vibration applied to the fuse 210 by being disposed to be in physical contact with the fuse 210 while maintaining an electrically insulated state with the fuse 210. The vibration detection element 230 may be configured to detect vibration of the fuse box by being disposed on the fuse case terminal 224 as illustrated in FIGS. 4 and 5 or disposed on one surface of the fuse case 220. In addition, the vibration detection element 230 may be configured to directly detect vibration applied to the fuse by being disposed on one surface of the fuse cover 221.

When the fuse box 200 accommodates a plurality of fuses 210 and is positioned on one side of the bus bar 300 connected to the outside of the battery pack 10, vibration may flow into the fuse 210 and the fuse box 200 in a process in which the vibration delivered from the outside through the bus bar 300 is delivered to the inside of the pack. Accordingly, the vibration detection element 230 may be attached to be positioned on at least one surface of the fuse box 200 so as to detect the vibration flowing into the bus bar 300.

When the fuse box 200 accommodates one fuse 210 and is positioned to be connected between the terminal of the battery module 100 and the bus bar 300, each of the battery modules 100 is connected to the bus bar 300 through a plurality of fuses 210. Therefore, when vibration generated outside the battery pack 10 flows into the battery pack 10 through the bus bar 300, the vibration is also delivered to the fuse 210 and the fuse box 200 before being delivered to the battery module 100. Accordingly, the vibration detection element 230 may be attached to each of the plurality of fuse boxes 200 to detect vibration delivered to the fuse box 200 connected to the terminal of the battery module 100.

When the vibration detection element 230 described above is mounted on the battery pack 10 for a vehicle, the purpose of the vibration detection element 230 is to detect vibration and vibration delivered to the fuse box 200 during driving. Therefore, the vibration detection element 230 is transferred in a form of a tape or in a form of a flexible protection circuit board (FPCB) transferred on a flexible substrate, and thus it is possible to sensitively detect that vibration generated during driving of a vehicle flows into the fuse box 200 and the bus bar 300 even a momentary moment, and to continuously detect vibration without being damaged even by a temporary impact.

As illustrated in FIG. 2, the vibration detection element 230 is directly connected to a CMC 410 of the BMS 400 with a ring terminal or a wire harness connection structure through terminals formed at both ends thereof, and is connected to a master BMS 400 through a BMIC 411 of the CMC 410 and delivers a change in resistance due to detected vibration to the BMS 400.

### C. bus bar 300

FIGS. 1 and 6 illustrate a configuration of the bus bar 300. Although only one bus bar 300 is illustrated in the drawing, negative/positive bus bars to which the module terminals (negative/positive terminals) of the battery modules 100 are respectively connected may be formed, and one end thereof is connected to an external electrode terminal (not illustrated) of the battery pack 10

The bus bar 300 may electrically connect the at least one battery module 100 to each other through a module terminal (not illustrated), and may be electrically coupled to each battery module 100 through the fuse 210.

The bus bar 300 is connected to the fuse case-bus bar terminal 223 through the fuse case terminal 224 of the fuse box 200. One end of the bus bar 300 is partially exposed to the outside of the battery pack 10 to be connected to the external electrical equipment of the battery pack 10 and is connected to the BMS, and through this, vibration from the outside of the battery pack 10 is delivered to the inside of the pack. In addition, when vibrations are accumulated, cumulative damage may occur. In the bus bar 300, a portion thereof connected to the fuse box 200 or the external BMS 400 may be damaged due to vibration generated outside the battery pack 10 such as driving of a vehicle and accumulated damage resulting therefrom, thereby causing a communication error with the battery module 100.

The vibration detection element 230 is mounted on one surface of the fuse box 200 including a plurality of fuses 210 as described above, but, in contrast to this, when the vibration detection element 230 is not positioned on one surface of the bus bar 300, in order to prevent damage due to accumulated damage caused by vibrations flowing into the bus bar 300, the vibration detection element 230 may also be attached to one end of the bus bar 300 connected to the external BMS 400.

### D. battery management system (BMS) (400)

FIG. 2 illustrates a connection relationship between the battery pack 10 and the BMS 400.

The BMS 400 may be formed separately from the battery pack or formed inside the battery pack. When the BMS 400 is formed separately from the battery pack 10, the battery pack 10 is limited to a configuration including the battery modules 100 and the bus bar 300 connecting the modules 100.

The BMS 400 may be configured to be included in each module as a module BMS, and in this case, at least one module BMS functions as a master BMS 420.

The BMS 400 collectively refers to a battery management system, and includes a cell monitoring circuit (CMC) 410, a battery monitoring circuit (BMIC) 411 which is a battery monitoring IC, and the Master BMS 420 that manages the entire system.

### (1) cell monitoring circuit (CMC) 410

The CMC 410 is a circuit inserted into the battery module 100 and is connected to the vibration detection element 230 through the internal BMIC 411 to check a state of the battery cell.

### (2) battery monitoring circuit (BMIC) 411

The BMIC 411 is directly connected to both ends of the vibration detection element 230 to monitor the change in the voltage value due to vibration or mechanical deformation of the fuse box 200 and the bus bar 300, and delivers detected information to the Master BMS 420.

### (3) master BMS 420

The master BMS 420 is a BMS that manages the entire battery system, and communicates with the vehicle through MCU, and receives voltage value change information according to vibration or mechanical deformation of the battery cell and the module by the vibration detection element 230 from the BMIC 411 of the CMC 410. By classifying the voltage value into a predetermined reference level according to the maximum allowable deformation specification of the vibration detection element 230, the protection operation of the battery pack 10 may be performed according to a range of detected vibration, and an alarm may be transmitted to the user.

For example, a first level based on an initial state level that is a level of the vibration detection element in a state before deformation, a second level that is the maximum allowable level of deformation, and third and fourth levels that exceed the maximum allowable level of deformation may be designated as reference levels. When vibration detected by the vibration detection element exceeds the second level, an alarm may be transmitted to the user, when the third level is exceeded, the alarm is transmitted, the battery is charged and discharged, and the vehicle is operated below a rated rating, and when the fourth level is exceeded, it is determined, by the user, that vibration detection element 230 is damaged and a measurement impossible alarm may be transmitted. The detection level reference and detection time according to the change in the resistance value of the vibration detection element 230 may be changed according to a user's request.

Meanwhile, configurations indicated by the reference numerals used in the drawings of the present invention are as follows.

10: battery pack
100: battery module
200: fuse box
210: fuse
211: fuse breakage part
212: fuse terminal
220: fuse case
221: fuse cover
222: fuse case-battery terminal
223: fuse case-bus bar terminal
224: fuse case terminal
230: vibration detection element
300: bus bar
400: BMS
410: CMC
411: BMIC
420: Master BMS

## Claims

1. A battery pack (10) comprising:
one or more battery modules (100) provided with a plurality of battery cells;
a bus bar (300) connected to a module terminal of the battery module (100) to electrically connect the one or more battery modules (100); and
a fuse box (200) formed to include a fuse (210) at a position where an electrode terminal of the battery pack and the bus bar (300) are connected, or at a position where each of the one or more battery modules (100) and the bus bar (300) are connected;
a vibration detection element (230) which is insulated and attached to one surface of the fuse box (200) or one surface of the bus bar (300) that is connected to an outside of the battery pack to detect vibration flowing into the battery pack; and
a BMS (400) which performs a protective operation of the battery pack according to a range of the vibration detected from the vibration detection element (230).

2. The battery pack (10) of claim 1, wherein
the vibration detection element (230) is attached to the bus bar or the fuse box in a form of a tape or a form of an FPCB transferred on a flexible substrate to detect inflow of vibration.

3. The battery pack (10) of claim 1, wherein
the fuse box (200) is disposed at a connection portion between the bus bar (300) and the module terminal of the battery module (100) to form a path between the bus bar (300) and the battery module (100).

4. The battery pack (10) of claim 3, wherein
the fuse box (200) is configured to include
a fuse case-battery terminal (222) connected to the module terminal of the battery module (100);
a fuse case terminal (224) connected to the bus bar (300); and
the fuse (210) connecting the fuse case-battery terminal (222) and the fuse case terminal (224), and
connects the battery module (100) and the bus bar (300) through the fuse (210).

5. The battery pack (10) of claim 1, wherein
the fuse box (200) is disposed at one end of the bus bar (300) to form a path between the bus bar (300) and a BMS (400).

6. The battery pack (10) of claim 5, wherein
the fuse box (200) is configured to include
a fuse case-battery terminal (222) connected to the BMS (400),
a fuse case terminal (224)connected to one end of the bus bar (300), and
the fuse (210) connecting the fuse case-battery terminal (222) and the fuse case terminal (224), and
connects the bus bar (300) and the BMS (400) and the battery module (100) and the bus bar (300) through the fuse (210).

7. The battery pack of claim 4 or 6, wherein
the vibration detection element (230) is disposed so as to be insulated on a fuse case-bus bar terminal (223) extending from the fuse case terminal (224).

8. The battery pack of claim 4 or 6, wherein
the vibration detection element (230) is insulated so as to physically contact the fuse (210).

9. The battery pack of claim 4 or 6, wherein
the fuse box (200) includes a fuse cover (221) covering the fuse (210), and
the vibration detection element (230) is disposed on one surface of the fuse cover (221).

10. The battery pack (10) of claim 1, wherein
the vibration detection element (230) is configured to measure a change in voltage value according to vibration detection of the bus bar and the fuse box and deliver the voltage value to a BMS (400), and
the BMS is configured to compare the voltage value with a predetermined reference level, and perform a protection operation and transmit an alarm to a user when the voltage value exceeds a maximum allowable level at the predetermined reference level.

## Patentansprüche

1. Ein Batteriepack (10), umfassend:
ein oder mehrere Batteriemodule (100), die mit einer Vielzahl von Batteriezellen versehen sind;
eine Sammelschiene (300), die mit einem Modulanschluss des Batteriemoduls (100) verbunden ist, um das eine oder die mehreren Batteriemodule (100) elektrisch zu verbinden; und
einen Sicherungskasten (200), der so ausgebildet ist, dass er eine Sicherung (210) an einer Position enthält, an der ein Elektrodenanschluss des Batteriepacks und die Sammelschiene (300) verbunden sind, oder an einer Position, an der jedes des einen oder der mehreren Batteriemodule (100) und die Sammelschiene (300) verbunden sind;
ein Vibrationserfassungselement (230), das isoliert und an einer Oberfläche des Sicherungskastens (200) oder einer Oberfläche der Sammelschiene (300) angebracht ist, die mit einer Außenseite des Batteriepacks verbunden ist, um in das Batteriepack einströmende Vibrationen zu erfassen; und
ein BMS (400), das einen Schutzbetrieb des Batteriepacks gemäß einem Bereich der von dem Vibrationserfassungselement (230) erfassten Vibration durchführt.

2. Das Batteriepack (10) nach Anspruch 1, wobei
das Vibrationserfassungselement (230) an der Sammelschiene oder dem Sicherungskasten in Form eines Bandes oder in Form einer auf ein flexibles Substrat übertragenen FPCB angebracht ist, um ein Einströmen von Vibrationen zu erfassen.

3. Das Batteriepack (10) nach Anspruch 1, wobei
der Sicherungskasten (200) an einem Verbindungsabschnitt zwischen der Sammelschiene (300) und dem Modulanschluss des Batteriemoduls (100) angeordnet ist, um einen Pfad zwischen der Sammelschiene (300) und dem Batteriemodul (100) zu bilden.

4. Das Batteriepack (10) nach Anspruch 3, wobei
der Sicherungskasten (200) so konfiguriert ist, dass er Folgendes enthält:
einen Sicherungsgehäuse-Batterieanschluss (222), der mit dem Modulanschluss des Batteriemoduls (100) verbunden ist;
einen Sicherungsgehäuseanschluss (224), der mit der Sammelschiene (300) verbunden ist; und
die Sicherung (210), die den Sicherungsgehäuse-Batterieanschluss (222) und den Sicherungsgehäuseanschluss (224) verbindet, und
das Batteriemodul (100) und die Sammelschiene (300) durch die Sicherung (210) verbindet.

5. Das Batteriepack (10) nach Anspruch 1, wobei
der Sicherungskasten (200) an einem Ende der Sammelschiene (300) angeordnet ist, um einen Pfad zwischen der Sammelschiene (300) und einem BMS (400) zu bilden.

6. Das Batteriepack (10) nach Anspruch 5, wobei
der Sicherungskasten (200) so konfiguriert ist, dass er Folgendes enthält:
einen Sicherungsgehäuse-Batterieanschluss (222), der mit dem BMS (400) verbunden ist,
einen Sicherungsgehäuseanschluss (224), der mit einem Ende der Sammelschiene (300) verbunden ist, und
die Sicherung (210), die den Sicherungsgehäuse-Batterieanschluss (222) und den Sicherungsgehäuseanschluss (224) verbindet, und
die Sammelschiene (300) und das BMS (400) und das Batteriemodul (100) und die Sammelschiene (300) durch die Sicherung (210) verbindet.

7. Das Batteriepack nach Anspruch 4 oder 6, wobei
das Vibrationserfassungselement (230) so angeordnet ist, dass es auf einem Sicherungsgehäuse-Sammelschienenanschluss (223), der sich von dem Sicherungsgehäuseanschluss (224) erstreckt, isoliert ist.

8. Das Batteriepack nach Anspruch 4 oder 6, wobei
das Vibrationserfassungselement (230) so isoliert ist, dass es die Sicherung (210) physisch berührt.

9. Das Batteriepack nach Anspruch 4 oder 6, wobei
der Sicherungskasten (200) eine Sicherungsabdeckung (221) enthält, die die Sicherung (210) abdeckt, und
das Vibrationserfassungselement (230) auf einer Oberfläche der Sicherungsabdeckung (221) angeordnet ist.

10. Das Batteriepack (10) nach Anspruch 1, wobei
das Vibrationserfassungselement (230) so konfiguriert ist, dass es eine Änderung des Spannungswertes gemäß der Vibrationserfassung der Sammelschiene und des Sicherungskastens misst und den Spannungswert an ein BMS (400) liefert, und
das BMS so konfiguriert ist, dass es den Spannungswert mit einem vorbestimmten Referenzpegel vergleicht und einen Schutzbetrieb durchführt und einen Alarm an einen Benutzer sendet, wenn der Spannungswert einen maximal zulässigen Pegel bei dem vorbestimmten Referenzpegel überschreitet.

## Revendications

1. Un bloc-batterie (10) comprenant :
un ou plusieurs modules de batterie (100) pourvus d'une pluralité de cellules de batterie
une barre omnibus (300) connectée à une borne de module du module de batterie (100) pour connecter électriquement les un ou plusieurs modules de batterie (100) ; et
une boîte à fusibles (200) formée pour inclure un fusible (210) à une position où une borne d'électrode du bloc-batterie et la barre omnibus (300) sont connectées, ou à une position où chacun des un ou plusieurs modules de batterie (100) et la barre omnibus (300) sont connectés ;
un élément de détection de vibration (230) qui est isolé et fixé à une surface de la boîte à fusibles (200) ou à une surface de la barre omnibus (300) qui est connectée à un extérieur du bloc-batterie pour détecter une vibration s'écoulant dans le bloc-batterie ; et
un BMS (400) qui effectue une opération de protection du bloc-batterie en fonction d'une plage de la vibration détectée à partir de l'élément de détection de vibration (230).

2. Le bloc-batterie (10) selon la revendication 1, dans lequel
l'élément de détection de vibration (230) est fixé à la barre omnibus ou à la boîte à fusibles sous la forme d'un ruban ou sous la forme d'un FPCB transféré sur un substrat flexible pour détecter l'afflux de vibration.

3. Le bloc-batterie (10) selon la revendication 1, dans lequel
la boîte à fusibles (200) est disposée au niveau d'une partie de connexion entre la barre omnibus (300) et la borne de module du module de batterie (100) pour former un chemin entre la barre omnibus (300) et le module de batterie (100).

4. Le bloc-batterie (10) selon la revendication 3, dans lequel
la boîte à fusibles (200) est configurée pour inclure
une borne de boîtier de fusible-batterie (222) connectée à la borne de module du module de batterie (100) ;
une borne de boîtier de fusible (224) connectée à la barre omnibus (300) ; et
le fusible (210) connectant la borne de boîtier de fusible-batterie (222) et la borne de boîtier de fusible (224), et
connecte le module de batterie (100) et la barre omnibus (300) par l'intermédiaire du fusible (210).

5. Le bloc-batterie (10) selon la revendication 1, dans lequel
la boîte à fusibles (200) est disposée à une extrémité de la barre omnibus (300) pour former un chemin entre la barre omnibus (300) et un BMS (400).

6. Le bloc-batterie (10) selon la revendication 5, dans lequel
la boîte à fusibles (200) est configurée pour inclure
une borne de boîtier de fusible-batterie (222) connectée au BMS (400),
une borne de boîtier de fusible (224) connectée à une extrémité de la barre omnibus (300), et
le fusible (210) connectant la borne de boîtier de fusible-batterie (222) et la borne de boîtier de fusible (224), et
connecte la barre omnibus (300) et le BMS (400) et le module de batterie (100) et la barre omnibus (300) par l'intermédiaire du fusible (210).

7. Le bloc-batterie selon la revendication 4 ou 6, dans lequel
l'élément de détection de vibration (230) est disposé de manière à être isolé sur une borne de boîtier de fusible-barre omnibus (223) s'étendant depuis la borne de boîtier de fusible (224).

8. Le bloc-batterie selon la revendication 4 ou 6, dans lequel
l'élément de détection de vibration (230) est isolé de manière à entrer en contact physique avec le fusible (210).

9. Le bloc-batterie selon la revendication 4 ou 6, dans lequel
la boîte à fusibles (200) inclut un couvercle de fusible (221) recouvrant le fusible (210), et
l'élément de détection de vibration (230) est disposé sur une surface du couvercle de fusible (221).

10. Le bloc-batterie (10) selon la revendication 1, dans lequel
l'élément de détection de vibration (230) est configuré pour mesurer un changement de valeur de tension en fonction de la détection de vibration de la barre omnibus et de la boîte à fusibles et pour délivrer la valeur de tension à un BMS (400), et
le BMS est configuré pour comparer la valeur de tension à un niveau de référence prédéterminé, et pour effectuer une opération de protection et transmettre une alarme à un utilisateur lorsque la valeur de tension dépasse un niveau maximal admissible au niveau de référence prédéterminé.
